# EUROPÄISCHE PATENTANMELDUNG

(11) **EP 1 653 620 A2**
(43) Veröffentlichungstag der Anmeldung: **03.05.2006**
(21) Anmeldenummer: 05023104.2
(22) Anmeldetag: 22.10.2005
(51) Int. Cl.: H03K 17/945

(54) **Sicherheitseinrichtung**

(30) Priorität: 29.10.2004 DE 102004052569
(71) Anmelder: Pösse, Frank , Dipl.-Ing, 63791 Karlstein (DE)
(72) Erfinder: Pösse, Frank , Dipl.-Ing, 63791 Karlstein (DE)
(74) Vertreter: Brune, Axel

(57) **Zusammenfassung**

Sicherheitseinrichtung (1) zur Steuerung einer Energieübertragung von mindestens einer Quelle (10) zu mindestens einem Verbraucher (11) mit mindestens einem Schaltelement (7), wobei das Schaltelement (7) über eine Empfangs- und Auswerteeinheit (5) ansteuerbar ist, wobei die Empfangs- und Auswerteeinheit (5) mindestens zur Detektion eines zugeordneten Senders (4) innerhalb eines vorbestimmbaren Abstandes (L) geeignet ist.

## Beschreibung

Die vorliegende Erfindung betrifft eine Sicherheitseinrichtung gemäß dem Oberbegriff des Anspruchs 1.

Sicherheitseinrichtungen der zuvor genannten Art sind beispielsweise aus dem Bereich der Medizintechnik bekannt geworden. Im Rahmen eines Sicherheitsschalters für pneumatische Ansteuerung von Elektromotoren bei Behandlungsliegen wird beispielsweise in der DE 20 2004 003 416 U1 ein Sicherheitsschalter offenbart, bei dem ein ein- und aussteckbarer Sicherheitsschlüssel die Höhenverstellung der Behandlungsliege mittels Fußschalter und Rundumbügel sperrt und dadurch eine ungewollte Höhenverstellung bei Auslösen über Fußschalter oder Rundumbügel verhindert.

Als Nachteilig erweist sich jedoch die Handhabung eines derartig ausgestalteten Sicherheitsschalters. Insbesondere ist nicht auszuschließen, dass der steckbare Sicherheitsschlüssel in dem Sicherheitsschalter vergessen wird, wodurch die eigentliche Funktion, die Verhinderung einer unbefugten Ansteuerung der Behandlungsliege, selbstverständlich nicht länger gewährleistet werden kann. Wird der Steckschlüssel von dem autorisierten Bedienpersonal an einer mit der Kleidung verbundnen Kette getragen, so ist die Bewegungsfreiheit des Bedienpersonals erheblich eingeschränkt.

Hier setzt die vorliegende Erfindung an und macht es sich zur Aufgabe eine Sicherheitseinrichtung bereitzustellen, mit der ein Bedienfehler nahezu auszuschließen ist und deren Anwendung insbesondere nicht zu einer Einschränkung der Bewegungsfreiheit des Anwenders führt.

Erfindungsgemäß wird diese Aufgabe durch eine Sicherheitseinrichtung mit den kennzeichnenden Merkmalen des Anspruchs 1 gelöst. Dadurch, dass das Schaltelement über eine Empfangs- und Auswerteeinheit ansteuerbar ist, wobei die Empfangs- und Auswerteeinheit mindestens zur Detektion eines zugeordneten Senders innerhalb eines vorbestimmbaren Abstandes geeignet ist, wird eine Sicherheitseinrichtung bereitgestellt, bei der Bedienfehler ausgeschlossen werden können, da die Steuerung des Schaltelements durch Annäherung von Sender und Empfangs- und Auswerteeinheit übernommen wird. Für einen klassischen Anwendungsfall, der Sicherung einer elektrischen Verstellvorrichtung gegen unbefugte Benutzung bedeutet dies, dass die Stromversorgung der Behandlungsliege unterbrochen ist, so lange sich kein autorisiertes Bedienpersonal mit einem zugeordneten Sender innerhalb eines vorbestimmbaren Abstandes zu der Sicherheitseinrichtung aufhält. Die Sicherheitseinrichtung kann beispielsweise so ausgestaltet sein, dass das Schaltelement schließt, sobald sich autorisiertes Bedienpersonal mit einem zugeordneten Sender in der Nähe eines mit einer erfindungsgemäßen Sicherheitseinrichtung ausgestatteten Krankenbettes befindet. Verlässt das Personal den Raum, wird das Schaltelement in einem Zustand zurückversetzt, der keine Übertragung von Energie auf den Verbraucher erlaubt. Es ist ersichtlich, dass das Personal keinen Schaltvorgang aktiv tätigen muss, wodurch Bedienfehler ausgeschlossen werden können. Auch wird die Bewegungsfreiheit des Personals nicht eingeschränkt, da es für die Betätigung des Schaltelements lediglich auf eine vorbestimmbare Nähe zwischen Sender und Empfangs- und Auswerteeinheit ankommt. Selbstverständlich sind auch weitere Anwendungsfälle mit anderen Schaltzuständen denkbar, beispielsweise kann das Schaltelement auch Ausschalten, wenn sich der Sender innerhalb des vorbestimmbaren Abstandes befindet.

In einer vorteilhaften Ausgestaltung der vorliegenden Erfindung kann vorgesehen sein, dass die Sicherheitseinrichtung über ein Gehäuse verfügt, wobei die Empfangs- und Auswerteeinheit mit einer Antenne ausgestattet ist, die wahlweise innerhalb oder außerhalb des Gehäuses angeordnet sein kann. Durch diese Maßnahme kann eine von der Position der Sicherheitseinrichtung unabhängige Festlegung des Empfangsmittelpunktes bzw. des durch den Abstand festlegbaren Aktivierungsradius festgelegt werden, da die Antenne beispielsweise an einer beliebigen Position angebracht werden kann.

Auch kann in einer vorteilhaften Ausgestaltung der Erfindung vorgesehen sein, dass die Sicherheitseinrichtung mit einer Batterie oder einem Akku zur Bereitstellung einer Betriebsspannung ausgestattet ist. Dementsprechend kann eine Versorgung der Empfangs- und Auswerteeinheit und des Schaltelements unabhängig von einer Versorgungsspannung stattfinden, die beispielsweise über den Eingang abgegriffen werden kann. Für den Fall, dass die Sicherheitseinrichtung im Bereich der hydraulischen und/oder pneumatischen Steuerung eingesetzt wird, ist eine derartige elektrische Versorgung über den Eingang jedoch nicht vorgesehen, so dass insbesondere hier vorteilhafterweise auf eine Batterie oder einen Akku zurückgegriffen werden kann.

Für den Anwendungsfall der Sicherheitseinrichtung innerhalb elektrischer Systeme kann vorteilhafterweise vorgesehen sein, dass es sich bei dem mindestens einen Schaltelement um ein Relais oder einen Hochleistungshalbleiterschalter handelt.

In diesem Zusammenhang kann ebenfalls vorteilhafterweise vorgesehen sein, dass der mindestens eine Eingang und/oder der mindestens eine Ausgang als elektrisches Anschlusskabel ausgestaltet ist. Durch diese Maßnahme kann die Sicherheitseinrichtung der äußeren Form eines herkömmlichen Verlängerungskabel angenähert werden, wodurch sich eine große Anzahl von Einsatzmöglichkeiten im Bereich der Elektrotechnik ergeben.

Auch kann vorteilhafterweise vorgesehen sein, dass der mindestens eine Eingang und/oder der mindestens eine Ausgang als Anschlussklemme, Stecker oder Buchse ausgestaltet ist. Dementsprechend wird eine kompakte Bauweise und Integration der Sicherheitseinrichtung in eine bestehende Anlage ermöglicht.

Für eine Anwendung der erfindungsgemäßen Sicherheitseinrichtung im Bereich der Pneumatik bzw. Hydraulik kann vorteilhafterweise vorgesehen sein, dass es sich bei dem Schaltelement um ein Ventil handelt. Durch eine derartige Ausgestaltung der Sicherheitseinrichtung ist beispielsweise auch ein Einsatz in explosionsgefährdeter Umgebung möglich, da hier keine elektrischen Entladungen erwartet werden müssen.

In diesem Zusammenhang kann ebenfalls vorteilhafterweise vorgesehen sein, dass der mindestens eine Eingang und/oder der mindestens eine Ausgang als Druckanschlussschlauch ausgestaltet ist. Dementsprechend kann eine Zwischenschaltung der erfindungsgemäßen Sicherheitseinrichtung nach dem Schema einer Schlauchverlängerung vorgenommen werden, wodurch sich ebenfalls mannigfaltige Einsatzmöglichkeiten im Bereich der Hydraulik bzw. Pneumatik ergeben.

Zur Verhinderung einer nicht autorisierten Überbrückung der Sicherheitseinrichtung kann vorteilhafterweise vorgesehen sein, dass der mindestens eine Eingang und oder der mindestens eine Ausgang mit mindestens einem Verriegelungselement ausgestattet ist, welches dazu geeignet ist ein unbefugtes Entfernen der Sicherungseinrichtung zwischen der Energiequelle und dem Verbraucher zu verhindern.

In einer vorteilhaften Ausgestaltung kann vorgesehen sein, dass es sich bei der Energiequelle um einen elektrischen Netzanschluss handelt. Eine derart ausgestaltete Sicherheitseinrichtung lässt sich demnach an eine herkömmliche Steckdose anschließen.

In einer bevorzugten Ausführungsform der vorliegenden Erfindung kann vorgesehen sein, dass es sich bei dem Verbraucher um einen elektrischen Krankenhausliegenantrieb handelt. In einem derartigen Anwendungsbereich kommen die zahlreichen Vorteile der vorliegenden Erfindung besonders zum Tragen.

In weiteren vorteilhaften und lediglich exemplarisch genannten Einsatzfällen kann vorgesehen sein, dass es sich bei dem Verbraucher um einen Anwendungsgegenstand mit erhöhtem Sicherheitsrisiko, beispielsweise um eine Registrierkasse, einen elektrischen Rasenmäher, Kreissäge oder Trennschleifer handelt. Auch hier kann die erfindungsgemäße Sicherheitseinrichtung, insbesondere wenn sich ihre Gestalt einem herkömmlichen Verlängerungskabel annähert besonders vorteilhaft eingesetzt werden.

Für den Einsatz im Bereich der Pneumatik bzw. Hydraulik kann vorteilhafterweise vorgesehen sein, dass es sich bei dem Verbraucher um einen Hydraulik- oder Pneumatikantrieb handelt.

In einer besonders vorteilhaften Ausgestaltung der vorliegenden erfinderischen Sicherheitseinrichtung kann vorgesehen sein, dass die Sicherungseinrichtung in eine Mehrfachsteckerleiste oder eine Kabeltrommel integriert ist. Hier kann eine besonders universelle Anwendbarkeit für nachgeschaltete Verbraucher sichergestellt werden.

Auch kann vorteilhafterweise zur Unterstützung der Bewegungsfreiheit des autorisierten Benutzers vorgesehen sein, dass der Sender als Chipkarte ausgestaltet ist. Selbstverständlich kann auch eine separate Stromversorgung für die Chipkarte vorgesehen sein.

Zur Gewährleistung einer besonders vorteilhaften Handhabung der vorliegenden erfinderischen Sicherheitseinrichtung kann vorgesehen sein, dass die Empfangs- und Auswerteeinheit zur Detektion des Senders mittels elektromagnetischer Wellen eingerichtet ist. Dementsprechend ist es nicht zwingend vorgesehen, dass Sender und Empfang- und Auswerteeinheit in "Sichtkontakt" zueinander stehen müssen. Der Sender kann vielmehr auch innerhalb einer Tasche aufbewahrt werden.

Für eine Erweiterung der erfindungsgemäßen Sicherungseinrichtung kann vorteilhafterweise vorgesehen sein, dass die Empfangs- und Auswerteeinheit um eine Sendeeinheit und der Sender um eine Empfangseinheit erweitert sein kann. Dementsprechend können beispielsweise beliebig ausgestaltete bidirektionale digitale Authentifikationsverfahren zwischen dem Sender und der Empfangs- und Auswerteeinheit zur Anwendung kommen.

In einer vorteilhaften Weiterbildung der vorliegenden Erfindung kann vorgesehen sein, dass der Sender mit einem Aktivierungsmittel ausgestattet ist. Dementsprechend kann eine Aktivierung des Schaltmittels vermieden werden, wenn der Sender beispielsweise nur zufällig in der Reichweite der Antenne bzw. Empfangs- und Auswerteeinheit liegt.

Als vorteilhafte Ausgestaltung des Aktivierungsmittels kann vorgesehen sein, dass es sich bei dem Aktivierungsmittel um einen Rüttelschalter und/oder Wärmeschalter handelt.

In einer weiteren Ausgestaltung der vorliegenden Erfindung kann vorgesehen sein, dass das Schaltelement dazu eingerichtet ist, dass es bei einem Ausfall der Betriebsspannung in einen gesicherten Zustand fällt. Dementsprechend kann sichergestellt werden, dass beispielsweise bei einem erneuten Einsetzen der Batterie oder der Stromversorgung der angeschlossene Verbraucher nicht automatisch anläuft.

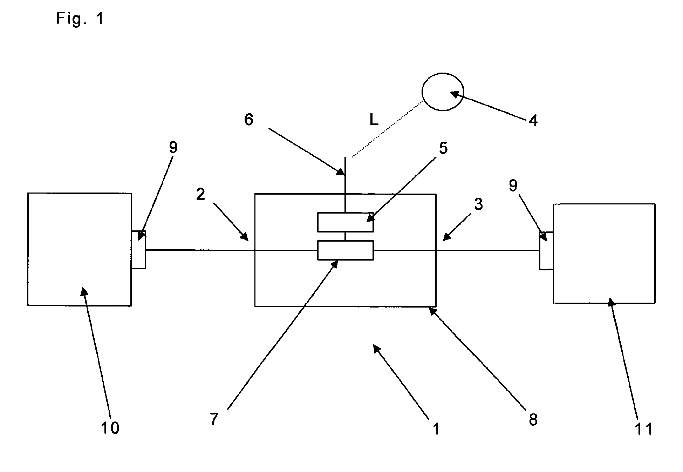

Weitere Merkmale und Vorteile der vorliegenden Erfindung werden deutlich anhand der nachfolgenden Beschreibung bevorzugter Ausführungsbeispiele unter Bezugnahme auf die beiliegende Abbildung. Darin zeigt
- Fig. 1: eine schematische Prinzipskizze einer erfindungsgemäßen Sicherheitseinrichtung.

Eine erfindungsgemäße Sicherheitseinrichtung 1 umfasst im wesentlichen einen Eingang 2 und einen Ausgang 3, wobei Ein- und Ausgang 2, 3 durch ein Schaltelement 7 vorzugsweise elektrisch miteinander verbunden bzw. getrennt werden können. In der hier vorliegenden bevorzugten Ausführungsform sind Ein- bzw. Ausgang 2, 3 als elektrische Anschlüsse in Form von Stromkabeln ausgestaltet, wobei der Eingang 2 jeweils mit einer Energiequelle 10, beispielsweise in Form eines Netzanschlusses und der Ausgang 3 mit einem Verbraucher 11, beispielsweise in Form eines Elektromotors für eine Behandlungsliege verbunden ist. Dementsprechend kann die Übertragung von Elektrizität von der Energiequelle 10 zum Verbraucher 11 durch das Schaltelement, welches hier vorzugsweise als Relais oder als Hochleistungshalbleiterschalter ausgebildet ist, freigegeben bzw. unterbunden werden.

Es ist selbstverständlich denkbar, dass die Sicherheitseinrichtung 1 auch auf eine hydraulische oder pneumatische Energiequelle 10 bzw. Verbraucher 11 angepasst werden kann. Dementsprechend wären der Ein- und Ausgang 2, 3 als Druckanschlüsse bzw. Druckleitungen und der Verbraucher als Hydraulikmotor, Hydraulikstößel oder ähnliche, zur Umsetzung von hydraulischer bzw. pneumatischer Energie in translatorische bzw. rotatorische Bewegung geeignete Vorrichtung auszugestalten. Auch ist selbstverständlich denkbar, dass eine Vielzahl von Ein- und Ausgängen 2, 3 und zugeordnete Schaltelemente 7 vorgesehen sind. Darüber hinaus sind auch kombinierte Sicherheitseinrichtungen mit elektrischen als auch pneumatischen und/oder hydraulischen Ein- bzw. Ausgängen 2, 3 und zugeordneten Schaltelementen 7 denkbar.

Erfindungsgemäß ist weiterhin vorgesehen, dass die Sicherheitseinrichtung 1, insbesondere das Schaltelement 7 von einer Empfangs- und Auswerteeinheit 5 angesteuert werden kann, wobei der Empfangs- und Auswerteeinheit 5 wiederum ein Sender 4 zugeordnet ist. Die Kombination aus Sender 4 und Empfangs- und Auswerteeinheit 5 ist grundsätzlich dazu geeignet das Schaltelement 5 anzusteuern sobald der Sender 4 eine vorbestimmbare Entfernung L zu der Empfangs- und Auswerteeinheit 5 unterschritten hat. Eine derartige Annäherungssensierung kann beispielsweise durch eine geeignete Sendesignalstärke und/oder Empfangs- und Auswerteeinheitempfindlichkeit eingestellt werden. Selbstverständlich kann auch eine geeignete Auswahl der Sendefrequenz zu einer Abstimmung der Annäherungssensierung beitragen. Auch sind Übertragungsstrategien mittels Bluetooth oder WLAN zwischen Sender 4 und Empfangs- und Auswerteeinheit 5 denkbar. Auch kommen sogenannte gemischte UHF/LF (Ultra High Frequency/Low Frequency) Übertragungsstrategien in Frage, wobei die Annäherung zunächst durch ein senderseitiges LF-Signal mit begrenzter Reichweite detektiert wird und in einem nächsten Schritt Authentifizierungsdaten per UHF zwischen Sender 4 und Empfangs- und Auswerteeinheit 5 bzw. vice versa übertragen werden. Denkbar sind auch weitere Strategien, beispielsweise ist die Empfangs- und Auswerteeinheit 5 gleichermaßen zur Abstrahlung eines LF-Signals mit beschränkter Reichweite geeignet, wobei der Sender 4 ebenfalls zum Empfang dieses LF-Signals geeignet ist. Empfängt der Sender 4 dieses "LF-Wake-up-Signal", wird der Datenaustausch zwischen Sender 4 und Empfangs- und Auswerteeinheit 5 mittels UHF ausgelöst. Wird hier ein gültiger digitaler Schlüssel übertragen, steuert die Empfangs- und Auswerteeinheit 5 das Schaltelement 7 an, wodurch der Eingang 2 vorzugsweise mit dem Ausgang 3 elektrisch verbunden wird, wodurch der Verbraucher 11 letztendlich mit Energie versorgt werden kann.

Dementsprechend können gezielt Sender 4 und Empfangs- und Auswerteeinheit 5 einander zugeordnet werden, so dass beispielsweise mehrere Sender 4 gleichzeitig innerhalb der vorbestimmbaren Entfernung L vom Empfangs- und Auswerteeinheit vorhanden sein können, die Sicherheitseinrichtung jedoch nur gezielt von einem Sender angesteuert wird. Selbstverständlich können einem Empfangs- und Auswerteeinheit 5 auch mehrere Sender 4 zugeordnet werden. Auch können einer Anzahl Empfangs- und Auswerteeinheit 5 auch ein einziger Sender 4 zugeordnet werden. Hier sind unterschiedliche Kombinationsmöglichkeiten denkbar.

Es ist weiterhin vorgesehen, dass die Empfangs- und Auswerteeinheit 5 mit einer entsprechenden Antenne 6 ausgestattet ist, wobei die Empfangs- und Auswerteeinheit 5, das Schaltelement 7 und die Antenne 6 in einem Gehäuse 8 untergebracht sind. Auch ist vorgesehen, dass die Ein- und Ausgänge 2, 3 in Form von Kabeln in das Gehäuse 8 eingeführt bzw. aus dem Gehäuse 8 ausgeführt werden können. Selbstverständlich kann auch vorgesehen sein, dass die Ein- und Ausgänge 2, 3 als Anschlussklemme oder Stecker/Buchse ausgestaltet sind.

In einer vorteilhaften Ausgestaltung der vorliegenden Erfindung kann weiterhin vorgesehen sein, dass die Antenne 6 außerhalb des Gehäuses 8 angeordnet ist. Hierdurch ergeben sich weitere Möglichkeiten der individuellen Anpassung der Sicherheitseinrichtung 1, insbesondere kann der vorbestimmte Empfangsbereich durch eine außerhalb des Gehäuses 8 vorgesehen Antenne 6 entsprechend verlagert und an die jeweiligen Verhältnisse angepasst werden. Denkbar sind jedoch ebenfalls Ausführungsformen die wegen der geringen Leistung ohne Antenne 6 auskommen bzw. bei denen die Antenne 6 mit auf der Leiterplatte angebracht bzw. aufgebracht ist.

Zur Betriebsstromversorgung der Sicherheitseinrichtung 1 ist eine Batterie 12 oder Akku vorgesehen. Denkbar ist selbstverständlich auch, dass die Sicherheitseinrichtung über die am Eingang 2 anliegende Netzspannung ggf. über einen geeigneten Spannungswandler versorgt wird. Auch sind Ausführungsformen denkbar, bei denen die Spannungsversorgung durch Solarzellen und/oder per Induktivschleife eingebracht wird.

Es ist weiterhin vorteilhafterweise vorgesehen, dass die Ein- und Ausgänge 2, 3, sofern sie als Kabel oder Schlauch ausgestaltet sind, endseitig mit Verriegelungselementen 9 ausgestattet sind, die zur Fixierung mit Anschlusselementen, beispielsweise Steckdosen oder Druckanschlüssen geeignet sind. Insbesondere kann vorgesehen sein, dass die Verriegelungselemente mit Schlössern ausgestattet sind, die eine nicht autorisierte Entfernung der Sicherheitseinrichtung 1 und Überbrückung durch ein herkömmliches Verlängerungskabel zwischen Energiequelle 10 und Verbraucher 11 verhindern können.

Insgesamt ergibt sich eine Sicherheitseinrichtung 1, die eine Vielzahl von Anwendungsmöglichkeiten bietet. Insbesondere für den Fall, dass die Sicherheitseinrichtung 1 in Form eines elektrischen Verlängerungskabels ausgestaltet ist, ergeben sich zahlreiche Anwendungsmöglichkeiten. Denkbar ist beispielsweise auch, die Sicherheitseinrichtung 1 in eine herkömmliche Mehrfachsteckerleiste oder Kabeltrommel zu integrieren. So ergeben sich neben Anwendungsmöglichkeiten in der Medizintechnik, insbesondere die Deaktivierung des Hubantriebes einer Therapieliege bzw. Krankenhausbett auch Einsatzgebiete im Bereich der Elektronik oder Haushaltstechnik. So kann beispielsweise ein Elektromäher mit einer erfindungsgemäßen Sicherheitseinrichtung angeschlossen oder auch ausgestattet sein, so dass das Schneideblatt nur bei Anwesenheit einer authentifizierten Person angetrieben werden kann. Dementsprechend kann die Verletzungsgefahr, beispielsweise spielender Kinder ausgeschlossen werden. Des Weiteren sind selbstverständlich weitere Verwendungen im Bereich besonders sicherheitsgefährdeter Werkzeuge, wie beispielsweise elektrische Kreissägen, Trennschleifer etc. denkbar. Auch sind Einsatzmöglichkeiten im Bereich der Computertechnik denkbar, beispielsweise können Kassensysteme oder Monitore über eine erfindungsgemäße Sicherheitseinrichtung angeschlossen sein um eine unbefugte Benutzung auszuschließen. Wie diese kleine Auswahl von Anwendungsbeispielen zeigt sind die denkbaren Anwendungsmöglichkeiten nahezu unbegrenzt.

## Patentansprüche

1. Sicherheitseinrichtung (1) zur Steuerung einer Energieübertragung von mindestens einer Quelle (10) zu mindestens einem Verbraucher (11) mit mindestens einem Schaltelement (7), **dadurch gekennzeichnet, dass** das Schaltelement (7) über eine Empfangs- und Auswerteeinheit (5) ansteuerbar ist, wobei die Empfangs- und Auswerteeinheit (5) mindestens zur Detektion eines zugeordneten Senders (4) innerhalb eines vorbestimmbaren Abstandes (L) geeignet ist.

2. Sicherheitseinrichtung nach Anspruch 1, **dadurch gekennzeichnet, dass** die Sicherheitseinrichtung (1) über ein Gehäuse (8) verfügt, wobei die Empfangs- und Auswerteeinheit (5) mit einer Antenne (6) ausgestattet ist, die wahlweise innerhalb oder außerhalb des Gehäuses (8) angeordnet sein kann.

3. Sicherheitseinrichtung nach einem der vorhergehenden Ansprüche, **dadurch gekennzeichnet, dass** die Sicherheitseinrichtung (1) mit einer Batterie (12) und/oder einem Akku und/oder einer Solarzelle und/oder einer Induktivschleife zur Bereitstellung einer Betriebsspannung ausgestattet ist.

4. Sicherheitseinrichtung nach einem der vorhergehenden Ansprüche, **dadurch gekennzeichnet, dass** es sich bei dem mindestens einen Schaltelement (7) um ein Relais oder einen Hochleistungshalbleiterschalter handelt.

5. Sicherungseinrichtung nach einem der vorhergehenden Ansprüche, **dadurch gekennzeichnet, dass** der mindestens eine Eingang (2) und/oder der mindestens eine Ausgang (3) als elektrisches Anschlusskabel ausgestaltet ist.

6. Sicherungseinrichtung nach einem der vorhergehenden Ansprüche, **dadurch gekennzeichnet, dass** der mindestens eine Eingang (2) und/oder der mindestens eine Ausgang (3) als Anschlussklemme, Stecker oder Buchse ausgestaltet ist.

7. Sicherungseinrichtung nach einem der vorhergehenden Ansprüche, **dadurch gekennzeichnet, dass** es sich bei dem Schaltelement (7) um ein Ventil handelt.

8. Sicherungseinrichtung nach einem der vorhergehenden Ansprüche, **dadurch gekennzeichnet, dass** der mindestens eine Eingang (2) und/oder der mindestens eine Ausgang (3) als Druckanschlussschlauch ausgestaltet ist.

9. Sicherungseinrichtung nach einem der vorhergehenden Ansprüche, **dadurch gekennzeichnet, dass** der mindestens eine Eingang (2) und oder der mindestens eine Ausgang (3) mit mindestens einem Verriegelungselement (9) ausgestattet ist, welches dazu geeignet ist ein unbefugtes Entfernen der Sicherungseinrichtung (1) zwischen der Energiequelle (1) und dem Verbraucher (11) zu verhindern.

10. Sicherungseinrichtung nach einem der vorhergehenden Ansprüche, **dadurch gekennzeichnet, dass** es sich bei der Energiequelle um einen elektrischen Netzanschluss handelt.

11. Sicherungseinrichtung nach einem der vorhergehenden Ansprüche, **dadurch gekennzeichnet, dass** es sich bei dem Verbraucher (11) um einen elektrischen Krankenhausliegenantrieb handelt.

12. Sicherungseinrichtung nach einem der vorhergehenden Ansprüche, **dadurch gekennzeichnet, dass** es sich bei dem Verbraucher (11) um Anwendungsgegenstand mit erhöhtem Sicherheitsrisiko handelt.

13. Sicherungseinrichtung nach einem der vorhergehenden Ansprüche, **dadurch gekennzeichnet, dass** es sich bei dem Verbraucher (11) um einen elektrischen Rasenmäher handelt.

14. Sicherungseinrichtung nach einem der vorhergehenden Ansprüche, **dadurch gekennzeichnet, dass** es sich bei dem Verbraucher (11) um einen Hydraulik- oder Pneumatikantrieb handelt.

15. Sicherungseinrichtung nach einem der vorhergehenden Ansprüche, **dadurch gekennzeichnet, dass** die Sicherungseinrichtung in eine Mehrfachsteckerleiste oder eine Kabeltrommel integriert ist.

16. Sicherungseinrichtung nach einem der vorhergehenden Ansprüche, **dadurch gekennzeichnet, dass** der Sender (4) als Chip, vorzugsweise als Chipkarte ausgestaltet ist.

17. Sicherungseinrichtung nach einem der vorhergehenden Ansprüche, **dadurch gekennzeichnet, dass** die Empfangs- und Auswerteeinheit (5) zur Detektion des Senders (4) mittels elektromagnetischer Wellen eingerichtet ist.

18. Sicherungseinrichtung nach einem der vorhergehenden Ansprüche, **dadurch gekennzeichnet, dass** die Empfangs- und Auswerteeinheit (5) um eine Sendeeinheit und der Sender (4) um eine Empfangseinheit erweitert sein kann.

19. Sicherungseinrichtung nach einem der vorhergehenden Ansprüche, **dadurch gekennzeichnet, dass** der Sender (4) mit einem Aktivierungsmittel ausgestattet ist.

20. Sicherungseinrichtung nach einem der vorhergehenden Ansprüche, **dadurch gekennzeichnet, dass** es sich bei dem Aktivierungsmittel um einen Rüttelschalter und/oder Wärmeschalter handelt.

21. Sicherungseinrichtung nach einem der vorhergehenden Ansprüche, **dadurch gekennzeichnet, dass** das Schaltelement (7) dazu eingerichtet ist, dass es bei einem Ausfall der Betriebsspannung in einen gesicherten Zustand fällt.
